# EUROPEAN PATENT APPLICATION

(11) **EP 4 778 978 A1**
(43) Date of publication of application: **22.07.2026**
(21) Application number: 24865746.2
(22) Date of filing: 02.09.2024
(51) Int. Cl.: C08L 63/00, C08K 5/5435, C08G 59/42, H01L 23/29

(54) **LIQUID EPOXY RESIN COMPOSITION**

(30) Priority: 11.09.2023 KR 20230120637
(71) Applicant: Momentive Performance Materials Inc., Niskayuna, NY 12309 (US)
(72) Inventor: LEE, Dong Yul, Seongnam-si, Gyeonggi-do 13256 (KR); LEE, Kyung Hwan, Hwaseong-si, Gyeonggi-do 18475 (KR); LEE, Hwan Hee, Seoul 07365 (KR); KANG, Hong Gu, Suwon-si, Gyeonggi-do 16543 (KR); KONG, Byung Seon, Yongin-si, Gyeonggi-do 17013 (KR); IJIMA, Yoichiro, Fujisawa City, Kanagawa 251-0021 (JP); MOCHIZUKI, Kyohei, Yokohama City, Kanagawa 222--0011 (JP); SASAKI, Motoshi, Ohta City, Gunma 3700841 (JP); SIVASUBRAMANIAN, Karthikeyan, Bangalore 560102 (IN); KAUR, Banpreet, 14197 Berlin (DE); PHUKAN, Monjit, New York 10604 (US)
(74) Representative: Pfenning, Meinig & Partner mbB
(86) International application number: PCT/KR2024/013140
(87) International publication number: WO 2025/058305

(57) **Abstract**

The present invention relates to a liquid epoxy resin composition comprising an epoxy resin, a curing agent, a filler, and a siloxane, wherein the siloxane is a siloxane of a symmetric structure having an alicyclic epoxy group substituted at center silicon, and a semiconductor device molded by using the same.

## Description

### [Technical Field]

The present invention relates to a liquid epoxy resin composition and a semiconductor device molded by using the same.

### [Background Art]

A resin composition for encapsulation is used as a material that improves the properties and reliability of semiconductor devices by sealing semiconductor elements such as integrated circuits (ICs), large-capacity integrated circuits (LSIs), transistors, and diodes. Recently, as high integration of semiconductors is accelerated in accordance with trends in miniaturization, weight reduction, and high performance of electronic devices, research to improve the performance of materials used for sealing semiconductor devices is continuing in various fields. For example, Japanese Patent Publication No. 2017-197620 relates to an epoxy resin composition for semiconductor encapsulation, comprising an epoxy resin, a phenol resin curing agent and a filler, and discloses a technique for increasing electrical connection reliability by adjusting the content of a filler and the thermal elasticity of a cured product of an epoxy resin composition.

Semiconductor chips are being miniaturized particularly according to demands for high density and high integration of semiconductors, and for this purpose, wafer-level packages having the same size as semiconductor chips are widely used. In the case of a wafer level package, it is difficult to apply a transfer mold method due to limitations in filling, and a compression molding method is generally applied. In this case, when large-area molding is performed by applying a solid molding compound having poor flowability, an unfilled part frequently occurs, and thus, the application of a liquid molding compound is increasing.

However, a molding compound includes a large amount of filler to improve properties (e.g., inhibition of wafer warpage when applied to a semiconductor device). In the case of a liquid molding compound, when the content of the filler is increased, flowability may be reduced, resulting in poor ejection into a mold, and, during molding, high shear stress is applied, resulting in die floating, in which a wafer may deviate from the original position thereof.

Accordingly, there is a need to develop a liquid epoxy resin composition for an encapsulant, which comprises a filler in a high content (e.g., greater than 50 wt%) and has excellent dispersibility, flowability, discharge property, moldability and warpage inhibition properties.

### [Detailed Description of Invention]

### [Technical Problem]

The present invention provides a liquid epoxy resin composition having excellent dispersibility, flowability, and warpage inhibition properties, and a semiconductor device molded by using the same.

### [Technical Solution]

The present invention provides a liquid epoxy resin composition comprising an epoxy resin, a curing agent, a filler, and a siloxane, wherein the siloxane is a siloxane of a symmetric structure having an alicyclic epoxy group substituted at center silicon.

### [Advantageous Effects]

The present invention provides a liquid epoxy resin composition having excellent dispersibility, flowability, and warpage inhibition properties. By improving the dispersibility of a filler, even when a high content of the filler is included, the liquid epoxy resin composition according to the present invention can provide excellent flowability and warpage inhibition properties. Therefore, the liquid epoxy resin composition of the present invention can be applied to a compression molding method, in particular, a compression molding method for manufacturing a wafer level package.

### [Best Mode]

Hereinafter, the present invention will be described in detail. However, the present invention is not limited only by the following contents, and each component may be variously modified or optionally mixed as needed. Therefore, it should be understood to include all modifications, equivalents, and substitutes included in the spirit and scope of the present invention.

The "weight average molecular weight" used herein is measured by a conventional method known in the art, and can be measured by, for example, a gel permeation chromatograph (GPC) method. The "viscosity" is measured by a conventional method known in the art, and can be measured by using, for example, a Brookfield viscometer, at room temperature (25 °C). The "glass transition temperature" used herein is measured by a conventional method known in the art, and can be measured by, for example, thermomechanical analysis (TMA) or differential scanning calorimetry (DSC). The "particle size (D50)" is measured by a conventional method known in the art, and can be measured, for example, by a laser particle size analyzer.

### <Liquid Epoxy Resin Composition>

The liquid epoxy resin composition according to the present invention includes an epoxy resin, a curing agent, a filler, and a siloxane. By using a siloxane having a symmetrical structure in which a center silicon is substituted with an alicyclic epoxy group, the present invention provides a liquid epoxy resin composition having excellent mechanical properties as well as excellent dispersibility and flowability.

### Epoxy Resin

The liquid epoxy resin composition of the present invention includes an epoxy resin. The epoxy resin is used as a main resin and reacts with a curing agent to form a three-dimensional network structure after curing, thereby imparting strong and firm adhesive properties and heat resistance to an object to be adhered.

As the epoxy resin, epoxy resin commonly used in the art may be used. Non-limiting examples of a usable epoxy resin include a bisphenol A type epoxy resin, alicyclic type epoxy resin, cresol novolac type epoxy resin, bisphenol F type epoxy resin, bisphenol S type epoxy resin, naphthalene type epoxy resin, anthracene type epoxy resin, tetramethyl biphenyl type epoxy resin, phenol novolac type epoxy resin, bisphenol A novolac type epoxy resin, bisphenol S novolac type epoxy resin, biphenyl novolac type epoxy resin, naphthol novolac type epoxy resin, naphthol phenol coaxial novolac type epoxy resin, naphthol cresol coaxial novolac type epoxy resin, aromatic hydrocarbon form aldehyde resin modified phenol resin type epoxy resin, triphenyl methane type epoxy resin, tetraphenyl ethane type epoxy resin, dicyclopentadiene type epoxy resin, dicyclopentadiene phenol addition reaction type epoxy resin, biphenyl type epoxy resin, phenol aralkyl type epoxy resin, polyfunctional phenolic resin, naphthol aralkyl type epoxy resin, etc., and may include at least one of these epoxy resins.

In one example, the epoxy resin may include a bisphenol F-type epoxy resin; alicyclic epoxy resins such as (3',4'-epoxycyclohexane)methyl 3,4-epoxycyclohexyl carboxylate; aminophenol type epoxy resins such as p-(2,3-epoxypropoxy)-N,N-bis(2,3-epoxypropyl)aniline; or mixtures thereof.

In one example, the epoxy resin may include a bisphenol F-type epoxy resin, an alicyclic epoxy resin, and an aminophenol-type epoxy resin. In this case, the viscosity, modulus, glass transition temperature, etc. of the liquid epoxy resin composition can be effectively controlled, and excellent discharge properties, moldability, heat resistance, and temperature cycle characteristics can be secured.

As the epoxy resin, one having an epoxy equivalent weight (EEW) of 50-400 g/eq, for example, 90-300 g/eq, may be used. When the EEW is less than the range stated above, the curing density may be too high, resulting in the occurrence of excessive curing shrinkage, and brittleness may increase to cause cracks, and when the EEW exceeds the range stated above, the curing density is low, so that the heat resistance may be deteriorated.

As the epoxy resin, one having a viscosity (25 °C) of 100-2,000 Pa·s, for example, 200-1,500 Pa·s, may be used. When the viscosity is less than the range stated above, the viscosity of the liquid epoxy resin composition is too low, resulting in leakage from a mold during molding, and when the viscosity exceeds the range stated above, the viscosity is too high, lowering the flowability, so that the discharge property of the liquid epoxy resin composition is lowered and a discharge port may be clogged, and the liquid epoxy resin composition may not be sufficiently discharged into a mold, resulting in poor moldability of a product.

As the epoxy resin, one having a weight average molecular weight of 100-1,000 g/mol, for example, 200-350 g/mol, may be used. When the weight average molecular weight is less than the range stated above, volatilization may occur during molding, resulting in mold contamination, and when the weight average molecular weight exceeds the range stated above, intermolecular entanglement may reduce flowability, resulting in poor filler dispersion or reduced moldability.

On the basis of the total weight of the liquid epoxy resin composition, the content of the epoxy resin may be 2-20% by weight, for example, 5-10% by weight. When the content of the epoxy resin is less than the range stated above, adhesiveness, flowability, and formability may be deteriorated, and when the content of the epoxy resin exceeds the range stated above, reliability of a semiconductor may be deteriorated due to an increase in moisture absorption, and, due to a relative decrease in filler content, warpage or strength may be deteriorated due to an increase in thermal expansion coefficient.

### Curing Agent

The liquid epoxy resin composition of the present invention includes a curing agent. The curing agent reacts with the epoxy resin to promote curing of the composition.

As the curing agent, a curing agent known in the art to undergo a curing reaction with epoxy resin may be used, and acid anhydride, a phenolic compound, etc. may be used. For example, the curing agent may be acid anhydride, such as phthalic anhydride, hexahydrophthalic anhydride, methylhexahydrophtalic anhydride, trialkyltetrahydrophthalic anhydride, tetrahydrophthalic anhydride, and so on.

On the basis of the total weight of the liquid epoxy resin composition, the content of the curing agent may be 1-20% by weight, for example, 1-10% by weight. When the content of the curing agent is less than the range stated above, the curability and formability may be lowered, and when the content of the curing agent exceeds the range stated above, the reliability of the semiconductor may be deteriorated and the strength may be lowered, due to an increase in moisture absorption.

### Filler

The liquid epoxy resin composition of the present invention includes a filler. The filler serves to improve the mechanical properties (e.g., strength, heat resistance, etc.) of the liquid epoxy resin composition, to control the viscosity of the liquid epoxy resin composition to provide appropriate flowability, and to lower the amount of moisture absorption.

As the filler, any inorganic filler that is commonly used in the field of electronic materials may be used without particular limitation. In one example, inorganic fillers, such as silica, silica nitride, alumina, aluminum nitride, and boron nitride, may be used, and these may be used alone or in combination of two or more.

The shape of the filler is not particularly limited, and both angular and spherical shapes can be used. Non-limiting examples of the filler that can be used in the present invention include natural silica, synthetic silica, fused silica, etc., and spherical silica particles may be used. The filler may be used after surface treatment with epoxy silane, phenylamino silane, or amino silane, etc..

The filler may include two or more types of fillers having different particle sizes. In this case, formability and workability of the liquid epoxy resin composition can be further improved. In one example, the filler may include a first filler having an average particle diameter (D50) of 5-30 µm, for example, 10-25 µm, and a second filler having an average particle diameter (D50) of 0.1-3 µm, for example, 0.1-1 µm.

On the basis of the total weight of the liquid epoxy resin composition, the content of the filler may be 50-93% by weight, for example, 70-93% by weight. When the content of the filler is less than the range stated above, the moisture absorption of a cured material may increase, resulting in a decrease in the reliability of a semiconductor device, and excessive warpage due to an increased coefficient of thermal expansion may cause peeling due to stress. When the content of the filler exceeds the range stated above, the flowability may be lowered, and thus formability may be deteriorated.

### Siloxane

The liquid epoxy resin composition of the present invention includes a siloxane. The siloxane is a siloxane of a symmetric structure having an alicyclic epoxy group substituted at center silicon, and by using the siloxane having this structure, the filler can be effectively dispersed, thereby providing a liquid epoxy resin composition with excellent dispersibility, flowability and warpage inhibition properties.

The siloxane may be represented by Chemical Formula 1 below:

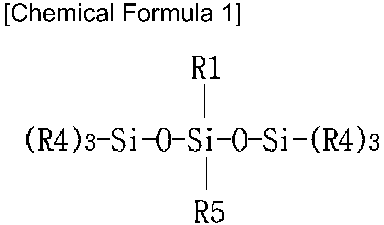

wherein:
R1 is 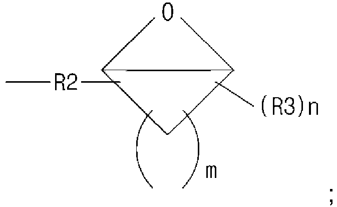
R2 is a substituted or unsubstituted hydrocarbon group having 1-5 carbon atoms;
R3 is a substituted or unsubstituted hydrocarbon group having 1-5 carbon atoms;
n is an integer from 0 to 3;
m is an integer from 2 to 8;
R4 is hydrogen or a substituted or unsubstituted hydrocarbon group having 1-3 carbon atoms; and
R5 is hydrogen or a substituted or unsubstituted hydrocarbon group having 1-3 carbon atoms.

In one example, in the above formula, R1 is 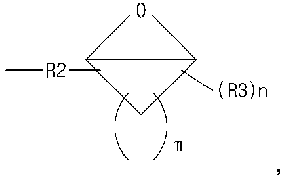 R2 is a substituted or unsubstituted alkyl group having 1-5 carbon atoms, R3 is a substituted or unsubstituted alkyl group having 1-5 carbon atoms, n is an integer from 0 to 3, m is an integer from 2 to 8, R4 is hydrogen or a substituted or unsubstituted alkyl group having 1-3 carbon atoms, and R5 is hydrogen or a substituted or unsubstituted alkyl group having 1-3 carbon atoms.

In one example, in the above formula, R1 is 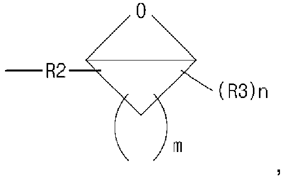 R2 is a substituted or unsubstituted alkyl group having 1-3 carbon atoms, R3 is a substituted or unsubstituted alkyl group having 1-3 carbon atoms, n is 0 or 1, m is an integer from 2 to 4, R4 is a substituted or unsubstituted alkyl group having 1-3 carbon atoms, and R5 is a substituted or unsubstituted alkyl group having 1-3 carbon atoms.

In one example, in the above formula, R1 is 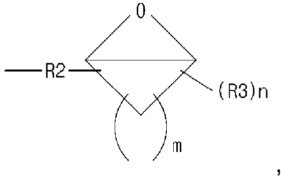 R2 is an ethyl group, n is 0, m is 4, R4 is a methyl group, and R5 is a methyl group.

In one example, the siloxane may be 3-[2-(3,4-epoxycyclohexyl)ethyl]-1,1,1,3,5,5,5-heptamethyltrisiloxane.

As the siloxane, one having a molecular weight of 200-800 g/mol, for example, 300-400 g/mol, may be used. When the molecular weight is less than the range stated above, it is difficult to exert sufficient steric hindrance effect when the siloxane is adsorbed on the surface of a filler, and reaggregation between adjacent fillers may occur. When the molecular weight exceeds the range stated above, the molecular size relative to the specific surface area of the filler may be too large to effectively cover the filler surface.

On the basis of the total weight of the liquid epoxy resin composition, the content of the siloxane may be 0.1-2% by weight, for example, 0.2-0.6% by weight. When the content of the siloxane is less than the range stated above, the dispersion effect is insignificant, so that the flowability may be lowered, and when the content of the siloxane exceeds the range stated above, the glass transition temperature of the liquid epoxy resin composition may be lowered, resulting in poor heat resistance.

### Additive(s)

The liquid epoxy resin composition of the present invention may additionally include additives that are commonly used in the composition. Non-limiting examples of usable additives include a catalyst, a coloring agent, and the like.

A catalyst promotes a curing reaction, and usable examples thereof may include an epoxy/amine adduct, an imidazole-based compound, a naphthalene-based latent catalyst, an amine-based compound, an organometallic compound, an organophosphorus compound, a boron compound, etc. A coloring agent is added to impart a color to the resin composition, and carbon black, bengala, etc. may be used as the coloring agent.

The additives may be added within a content range known in the art, and, for example, on the basis of the total weight of the liquid epoxy resin composition, may be included in an amount of 0.01-5% by weight, but is not limited thereto.

### <Semiconductor Device and Automotive Parts>

The present invention provides a molded semiconductor device using the above-described liquid epoxy resin composition. The semiconductor device may be a transistor, a diode, a microprocessor, a semiconductor memory, or a power semiconductor.

In addition, the present invention provides an automotive part molded by using the above-described liquid epoxy resin composition. In an example, the liquid epoxy resin composition can be used as a molding material to fix and seal components in an automotive part, and, specifically, a permanent magnet may be inserted into an empty space formed in a rotor core of a vehicle motor, and the liquid epoxy resin composition of the present invention may be filled between the empty space and the permanent magnet to fix the permanent magnet in the rotor core.

A method for molding a semiconductor device or molding an automotive part by using the liquid epoxy resin composition of the present invention may be appropriately selected and performed according to a conventional method in the art, for example, transfer molding, compression molding, injection molding, and the like.

### [Modes of the Invention]

Hereinafter, the present invention will be described in more detail through examples. However, the following examples are only for a better understanding of the present invention, and the scope of the present invention is not limited to the examples in any sense.

### [Experimental Examples 1-14]

Liquid epoxy resin compositions of the respective experimental examples were prepared by blending and uniformly mixing components according to the composition listed in Tables 1-3 below, followed by performing dispersion-kneading using 3-roll milling equipment.

**[Table 1]**

| Component (wt%) | Experimental Example 1 | Experimental Example 2 | Experimental Example 3 | Experimental Example 4 | Experimental Example 5 |
|---|---|---|---|---|---|
| Epoxy resin 1 | 2.7 | 2.33 | 3.08 | 2.74 | 2.67 |
| Epoxy resin 2 | 1.35 | 1.16 | 1.54 | 1.37 | 1.33 |
| Epoxy resin 3 | 2.7 | 2.33 | 3.08 | 2.74 | 2.67 |
| Curing agent | 7.4 | 6.37 | 8.44 | 7.51 | 7.3 |
| Filler 1 | 59 | 60 | 58 | 59 | 59 |
| Filler 2 | 26 | 27 | 25 | 26 | 26 |
| Siloxane 1 | 0.4 | 0.4 | 0.4 | 0.2 | 0.6 |
| Siloxane 2 | | | | | |
| Siloxane 3 | | | | | |
| Siloxane 4 | | | | | |
| Catalyst | 0.14 | 0.12 | 0.15 | 0.14 | 0.13 |
| Coloring agent | 0.3 | 0.3 | 0.3 | 0.3 | 0.3 |
| Total | 100 | 100 | 100 | 100 | 100 |

**[Table 2]**

| Component (wt%) | Experimental Example 6 | Experimental Example 7 | Experimental Example 8 | Experimental Example 9 | Experimental Example 10 |
|---|---|---|---|---|---|
| Epoxy resin 1 | 2.7 | 2.74 | 2.67 | 2.7 | 2.74 |
| Epoxy resin 2 | 1.35 | 1.37 | 1.33 | 1.35 | 1.37 |
| Epoxy resin 3 | 2.7 | 2.74 | 2.67 | 2.7 | 2.74 |
| Curing agent | 7.4 | 7.51 | 7.3 | 7.4 | 7.51 |
| Filler 1 | 59 | 59 | 59 | 59 | 59 |
| Filler 2 | 26 | 26 | 26 | 26 | 26 |
| Siloxane 1 | | | | | |
| Siloxane 2 | 0.4 | 0.2 | 0.6 | | |
| Siloxane 3 | | | | 0.4 | 0.2 |
| Siloxane 4 | | | | | |
| Catalyst | 0.14 | 0.14 | 0.13 | 0.14 | 0.14 |
| Coloring agent | 0.3 | 0.3 | 0.3 | 0.3 | 0.3 |
| Total | 100 | 100 | 100 | 100 | 100 |

**[Table 3]**

| Component (wt%) | Experimental Example 11 | Experimental Example 12 | Experimental Example 13 | Experimental Example 14 |
|---|---|---|---|---|
| Epoxy resin 1 | 2.67 | 2.7 | 2.74 | 2.67 |
| Epoxy resin 2 | 1.33 | 1.35 | 1.37 | 1.33 |
| Epoxy resin | 2.67 | 2.7 | 2.74 | 2.67 |
| Curing agent | 7.3 | 7.4 | 7.51 | 7.3 |
| Filler 1 | 59 | 59 | 59 | 59 |
| Filler 2 | 26 | 26 | 26 | 26 |
| Siloxane 1 | | | | |
| Siloxane 2 | | | | |
| Siloxane 3 | 0.6 | | | |
| Siloxane 4 | | 0.4 | 0.2 | 0.6 |
| Catalyst | 0.13 | 0.14 | 0.14 | 0.13 |
| Coloring agent | 0.3 | 0.3 | 0.3 | 0.3 |
| Total | 100 | 100 | 100 | 100 |

Epoxy resin 1: Bisphenol F epoxy resin (viscosity (25 °C) 1,300 m Pa·s, equivalent weight 159 g/eq, Mw 318 g/mol)
Epoxy resin 2: (3',4'-Epoxycyclohexane)methyl 3,4-epoxycyclohexylcarboxylate
Epoxy resin 3: p-(2,3-Epoxypropoxy)-N,N-bis(2,3-epoxypropyl)aniline
Curing agent: Methylhexahydrophtalic anhydride
Filler 1: Silica (D₅₀ 5 um, Cut size 20 um, Epoxy silane surface treatment)
Filler 2: Silica (D₅₀ 0.3 um, Cut size 1.0 um, Epoxy silane surface treatment)
Siloxane 1:
   3-[2-(3,4-epoxycyclohexyl)ethyl]-1,1,1,3,5,5,5-heptamethyltrisiloxane
Siloxane 2: 3-(3-glycidoxypropyl)-1,1,1,3,5,5,5-heptamethyltrisiloxane
Siloxane 3:
   1,3-bis[2-(3,4-epoxycyclohexyl)ethyl]-1,1,3,3-tetramethyldisiloxane
Siloxane 4: 1,3-bis[3-glycidoxypropyl]-1,1,3,3-tetramethyldisiloxane
Catalyst: Epoxy/amine adduct type (Cas no. 134091-76-2)
Coloring agent: Carbon black

### [Evaluation of properties]

The properties of the liquid epoxy resin compositions prepared in the respective experimental examples were measured as follows, and the results are shown in Tables 4-6 below.

### Viscosity

The viscosity of each of the liquid epoxy resin compositions of the respective experimental examples was measured at 0.2 RPM and 2.0 RPM at 25 °C and 120 °C using a rheometer (Anton Paar MCR302, spindle PP25, gap 0.5 mm). The thixotropic index was calculated by dividing the 0.2 RPM viscosity measurement by the 2 RPM viscosity measurement at each temperature.

### Coefficient of Thermal Expansion

After injecting each of the liquid epoxy resin compositions of the respective experimental examples into a mold having a size of 6 mm (length) × 6 mm (width) × 6 mm (thickness), each liquid epoxy resin composition was cured at 150 °C for 1 hour to prepare a specimen. The each cured specimen was heated from -20 °C to 300 °C at a temperature elevation rate of 10 °C/min by using TMA equipment (TA's Q400, Expansion mode), and then the coefficient of thermal expansion (CTE) of the re-cooled specimen was measured continuously. Among the second measurement results, the coefficient of thermal expansion at a temperature below the glass transition temperature (Tg) is represented by CTE α1, and the coefficient of thermal expansion at a temperature exceeding Tg is represented by CTE α2.

### Glass Transition Temperature (Tq)

After injecting each of the liquid epoxy resin compositions of the respective experimental examples into a mold having a size of 60 mm (length) × 12 mm (width) × 3 mm (thickness), each liquid epoxy resin composition was cured at 150 °C for 1 hour to prepare a specimen. The each specimen was heated at a temperature elevation rate of 5 °C/min from 25 °C to 260 °C by using a DMA device (Perkin Elmer's DMA 8000, 3 point bending mode), and the peak value of a tangent delta value was indicated as Tg.

### Discharge Property

After injecting each of the liquid epoxy resin compositions of the respective experimental examples into a syringe (Nordson EFD optimum syringe barrel 10 cc), a plunger was fastened to discharge at a discharge pressure of 1.0 bar for 1 minute using a dispenser (Nordson EFD Ultimus dispenser), and discharge properties were evaluated as follows:

### [Evaluation Criteria]

○: discharge amount of 200 g or more
X: discharge amount of less than 200 g

### Mold Evaluation

### Manufacture of Molded Product

Silicon chips were cut into a size of 7.8 mm × 7.8 mm by using a dicing machine (DISCO DFD6361). The 500 silicon chips were mounted on the surface of a thermal foam release sheet (Nitto Revalpha tape), which is attached to a 12-inch wafer used as a carrier, at appropriate intervals. The silicon chips formed on the carrier wafer was molded (pressure: 30 tons; molding temperature: 120 °C; and molding time: 10 min) using the liquid epoxy resin composition of each experimental example with a diameter of 297 mm and a thickness of 100 um by using a compression mold (ASM Compression molding machine). After curing each of the molded specimens at 150° C for 1 hour, the thermally foamed release sheet was foamed and removed on a hot plate at 200° C to obtain a molded product having silicon chips.

### Die Floating

During molding, a phenomenon in which a chip is separated from a thermal foam release sheet and buried in a liquid molding compound (LMC) may occur. The surface of each silicon chip of the molded product was observed, and the number of chips separated from the thermal foam release sheet was identified and evaluated as follows:

### [Evaluation Criteria]

∘: Occurrence of chip separation
X: Non-occurrence of chip separation

### Warpage

Each molded product was placed on a flat table, the maximum heights of both ends of which warpage occurred from the table were measured, and the average value was obtained, and the warpage characteristics were evaluated as follows:

### [Evaluation Criteria]

∘: Average value of 13 mm or less
X: Average value of greater than 13 mm

**[Table 4]**

| | | Experimental Example 1 | Experimental Example 2 | Experimental Example 3 | Experimental Example 4 | Experimental Example 5 |
|---|---|---|---|---|---|---|
| 25°C 2 RPM Viscosity (Pa·s) | | 340 | 670 | 155 | 433 | 279 |
| 25°C 0.2 RPM Viscosity (Pa·s) | | 680 | 1273 | 217 | 953 | 446 |
| 25°C Thixotropic index | | 2 | 1.9 | 1.4 | 2.2 | 1.6 |
| 120°C 2 RPM Viscosity (Pa·s) | | 14 | 39 | 7 | 29 | 11 |
| 120°C 0.2 RPM Viscosity (Pa·s) | | 15 | 109 | 16 | 35 | 13 |
| 120°C Thixotropic index | | 1.1 | 2.8 | 2.3 | 1.2 | 1.2 |
| CTE α1 | | 14 | 11 | 17 | 15 | 14 |
| CTE α2 | | 45 | 39 | 55 | 47 | 46 |
| Tg | | 154 | 151 | 156 | 156 | 148 |
| Discharge property | | ○ | ○ | ○ | ○ | ○ |
| Mold evaluation | Die floating | X | X | X | X | X |
| | Warpage | ○ | ○ | ○ | ○ | ○ |

**[Table 5]**

| | | Experimental Example 6 | Experimental Example 7 | Experimental Example 8 | Experimental Example 9 | Experimental Example 10 |
|---|---|---|---|---|---|---|
| 25°C 2 RPM Viscosity (Pa·s) | | 548 | 989 | 479 | 802 | 1537 |
| 25°C 0.2 RPM Viscosity (Pa·s) | | 1973 | 4352 | 2443 | 3850 | 7839 |
| 25°C Thixotropic index | | 3.6 | 4.4 | 5.1 | 4.8 | 5.1 |
| 120°C 2 RPM Viscosity (Pa·s) | | 68 | 77 | 55 | 71 | 87 |
| 120°C 0.2 RPM Viscosity (Pa·s) | | 82 | 162 | 72 | 263 | 252 |
| 120°C Thixotropic index | | 1.2 | 2.1 | 1.3 | 3.7 | 2.9 |
| CTE α1 | | 14 | 15 | 15 | 14 | 15 |
| CTE α2 | | 46 | 45 | 46 | 46 | 47 |
| Tg | | 153 | 154 | 151 | 154 | 154 |
| Discharge property | | X | X | X | X | X |
| Mold evaluation | Die floating | ○ | ○ | X | ○ | ○ |
| | Warpage | ○ | ○ | ○ | ○ | ○ |

**[Table 6]**

| | | Experimental Example 11 | Experimental Example 12 | Experimental Example 13 | Experimental Example 14 |
|---|---|---|---|---|---|
| 25°C 2 RPM Viscosity (Pa·s) | | 661 | 533 | 781 | 664 |
| 25°C 0.2 RPM Viscosity (Pa·s) | | 2776 | 1759 | 2734 | 1926 |
| 25°C Thixotropic index | | 4.2 | 3.3 | 3.5 | 2.9 |
| 120°C 2 RPM Viscosity (Pa·s) | | 55 | 33 | 58 | 21 |
| 120°C 0.2 RPM Viscosity (Pa·s) | | 149 | 56 | 168 | 44 |
| 120°C Thixotropic index | | 2.7 | 1.7 | 2.9 | 2.1 |
| CTE α1 | | 15 | 14 | 14 | 15 |
| CTE α2 | | 46 | 45 | 46 | 46 |
| Tg | | 149 | 155 | 156 | 150 |
| Discharge property | | X | X | X | X |
| Mold evaluation | Die floating | ○ | X | ○ | X |
| | Warpage | ○ | ○ | ○ | ○ |

As shown in Tables 4-6, the liquid epoxy resin compositions of Experimental Examples 1-5 including the siloxane according to the present invention of a symmetric structure having an alicyclic epoxy group substituted at center silicon (Siloxane 1) showed excellent properties in overall measurement items.

However, the liquid epoxy resin compositions of Experimental Examples 6-8 in which the siloxane of an asymmetric structure not having an alicyclic epoxy group (Siloxane 2) is used, the liquid epoxy resin compositions of Experimental Examples 9-11 in which the siloxane of a symmetric structure having an alicyclic epoxy group at both ends (Siloxane 3) is used, and the liquid epoxy resin compositions of Experimental Examples 12-14 in which the siloxane of a symmetric structure not having an epoxy group at both ends (Siloxane 4) is used, exhibited poor properties, compared to the liquid epoxy resin compositions of Experimental Examples 1-5. In particular, it was confirmed that the liquid epoxy resin compositions of Experimental Example 6-14 had poor discharge properties, die floating, or wafer warpage.

### [Industrial Applicability]

The present invention provides a liquid epoxy resin composition having excellent dispersibility, flowability, and warpage inhibition properties.

## Claims

1. A liquid epoxy resin composition comprising an epoxy resin, a curing agent, a filler, and a siloxane,
wherein the siloxane is a siloxane of a symmetric structure having an alicyclic epoxy group substituted at center silicon.

2. The liquid epoxy resin composition as claimed in claim 1, wherein the epoxy resin has an epoxy equivalent weight (EEW) of 50-400 g/eq, a viscosity (25 °C) of 100-2,000 Pa·s, and a weight average molecular weight of 100-1,000 g/mol.

3. The liquid epoxy resin composition as claimed in claim 1, wherein the curing agent is acid anhydride.

4. The liquid epoxy resin composition as claimed in claim 1, wherein the siloxane is represented by Chemical Formula 1 below: 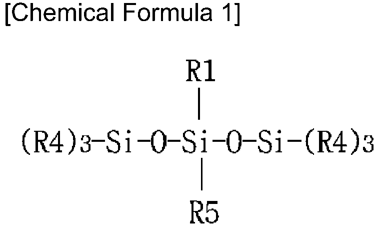 wherein:
R1 is 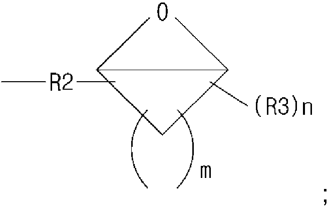
R2 is a substituted or unsubstituted hydrocarbon group having 1-5 carbon atoms;
R3 is a substituted or unsubstituted hydrocarbon group having 1-5 carbon atoms;
n is an integer from 0 to 3;
m is an integer from 2 to 8;
R4 is hydrogen or a substituted or unsubstituted hydrocarbon group having 1-3 carbon atoms; and
R5 is hydrogen or a substituted or unsubstituted hydrocarbon group having 1-3 carbon atoms.

5. The liquid epoxy resin composition as claimed in claim 1, wherein the siloxane has a molecular weight of 200-800 g/mol, and a viscosity (25 °C) of 0.1-1,000 Pa·s.

6. The liquid epoxy resin composition as claimed in claim 1, wherein, on the basis of the total weight of the liquid epoxy resin composition, the epoxy resin composition comprises 2-20% by weight of the epoxy resin, 1-20% by weight of the curing agent, 50-93% by weight of the filler, and 0.1-2% by weight of the siloxane.

7. A semiconductor device molded by using the liquid epoxy resin composition according to any one of claims 1 to 6.
